# EUROPÄISCHE PATENTSCHRIFT

(11) **EP 0 738 008 B1**
(45) Veröffentlichungstag und Bekanntmachung des Hinweises auf die Patenterteilung: **25.06.2003**
(21) Anmeldenummer: 96810191.5
(22) Anmeldetag: 26.03.1996
(51) Int. Cl.: H01L 25/18, H01L 23/64

(54) **Leistungshalbleitermodul**
Semiconductor power module
Module à semi-conducteur de puissance

(30) Priorität: 14.04.1995 US 422169
(43) Veröffentlichungstag der Anmeldung: 16.10.1996
(73) Patentinhaber: ABB Schweiz AG, 5400 Baden (CH)
(72) Erfinder: Stockmeier, Thomas, Dr., Rancho Palos Verdes, CA 90275 (US); Thiemann, Uwe, Dr., Rancho Palos Verdes, CA 90275 (US); Bayerer, Reinhold, Dr., 64385 Reichelsheim (DE)
(74) Vertreter: ABB Patent Attorneys

(56) Entgegenhaltungen:
- EP-A- 0 597 144
- DE-A- 3 937 045
- US-A- 5 291 065
- US-A- 5 347 160
- STOCKMEIER T ET AL: "RELIABLE 1200 AMP 2500 V IGBT MODULES FOR TRACTION APPLICATIONS" IEE COLLOQUIUM ON IGBT PROPULSION DRIVES, 25. April 1995, Seiten 3/1-3/13, XP002036952

## Beschreibung

### Technisches Gebiet

Die Erfindung bezieht sich auf das Gebiet der Leistungselektronik.

Sie geht aus von einem Leistungshalbleitermodul nach dem Oberbegriff des ersten Anspruchs.

### Stand der Technik

Leistungshalbleitermodule werden beispielsweise schon in den deutschen Offenlegungsschriften DE-A1-39 31 634 und DE-A1-43 30 070 beschrieben.

Bei diesen Leistungshalbleitermodulen, welche eine Grundplatte mit mindestens einem Leistungshalbleiterschaltelement umfassen, verlaufen die Leistungsanschlüsse senkrecht zur Grundplatte (siehe DE 39 31 634 Fig. 4 und Spalte 5, Zeilen 24 ff. und DE 43 30 070 Fig. 8). Die Leistungsanschlüsse werden senkrecht zur Grundplatte aus dem Modulgehäuse geführt. Dadurch müssen die Steuereinheiten in einer gewissen Entfernung z.B. oberhalb oder neben den Modulen angeordnet werden. Dies zieht relativ lange Anschlussleitungen zur Steuereinheit, welche der Ansteuerung des Moduls dient, mit sich. Die langen Anschlussleitungen ergeben eine unerwünscht hohe Induktivität der Anordnung, welche insbesondere im Hinblick auf hohe Schaltfrequenzen limitierend wirken kann.

US Patentschrift US 5 347 160 offenbart ein Leistungshalbleitermodul, bei dem die Leistungsanschlüsse parallel zur Grundplatte verlaufen, und bei dem die Steueranschlüsse rechtwinklig zur Grundplatte aus dem Gehäuse herausgeführt sind.

### Darstellung der Erfindung

Aufgabe der vorliegenden Erfindung ist es deshalb, ein Leistungshalbleitermodul anzugeben, bei welchem die Verbindungsleitungen zur Steuereinheit möglichst kurz sind und die Anordnung dadurch möglichst niederinduktiv wird.

Diese Aufgabe wird bei einem Leistungshalbleitermodul der eingangs genannten Art durch die Merkmale des ersten Anspruchs gelöst.

Kern der Erfindung ist es also, dass die Leistungsanschlüsse parallel zur Grundplatte verlaufen und parallel zur Grundplatte aus dem Gehäuse herausgeführt werden. Dadurch wird es möglich, die Steuereinheit direkt auf die der Grundplatte abgewandte Oberfläche des Modulgehäuses zu montieren. Dies ermöglicht die Verwendung von kurzen Verbindungsleitungen und damit einen niederinduktiven Aufbau.

Wird ausserdem derjenige Steueranschluss, welcher gegenüber der Steuereinheit die kleinste, idealerweise gar keine, Potentialdifferenz aufweist, am weitesten entfernt von der Grundplatte angeordnet, so wirkt dieser Leistungsanschluss für die Steuereinheit gerade auch noch als Abschirmung für elektromagnetische Felder, welche durch das Schalten des Moduls hervorgerufen werden.

Um die Steuereinheit auf dem Modul zu befestigen, sind Befestigungsmittel wie zum Beispiel Schraubenlöcher und Schrauben auf der von der Grundplatte abgewandten Seite des Modulgehäuses vorgesehen. Die Steuer- und Hilfsanschlüsse können auf die Oberseite des Gehäuses herausgeführt werden. Die Steuereinheit wird dann auf diese Anschlüsse gesteckt und die Verbindung zwischen den Steuerund Hilfsanschlüssen des Moduls und den entsprechenden Anschlüssen der Steuereinheit erfolgt z.B. mittels einfacher Schraub- oder Steckkontakte. Dadurch wird eine unmittelbare Verbindung zwischen den Steuer- und Hilfsanschlüssen und der Steuereinheit erreicht, und die ansonsten relativ lange und damit induktivitätsbehafteten Zuleitungen entfallen. Weitere Ausführungsbeispiele ergeben sich aus den entsprechenden abhängigen Ansprüchen.

Mit erfindungsgemässen Modulen lassen sich somit Schaltungsanordnungen herstellen, bei welchen die Steuereinheit der Module direkt auf den Modulen angebracht ist und bei welchen die Verbindung zwischen Modul und Steuereinheit in vorteilhafter Weise niederinduktiv aufgebaut werden kann, so dass die Module insbesondere für höhere Frequenzen eingesetzt werden können.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Einen Schnitt durch ein erfindungsgemässes, aufgeschnittenes Modul ohne Gehäuse;
- **Fig. 2**: Eine Aufsicht auf ein geöffnetes Modul nach der Erfindung;
- **Fig. 3**: Ein erfindungsgemässes Modul mit aufgepackter Steuereinheit von oben;
- **Fig. 4**: Ein Ersatzschaltbild einer Halbbrücke mit IGBTs;
- **Fig. 5**: Ein Schnittbild eines Halbbrückenmoduls.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

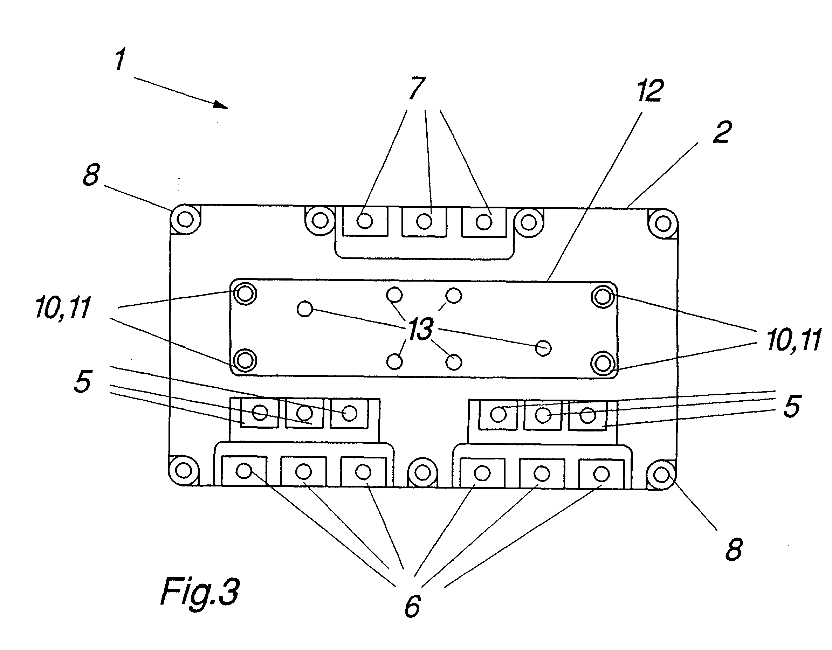

Figur 3 zeigt den Aufbau einer Schaltungsanordnung mit einem Leistungshalbleitermodul 1 und einer Steuereinheit 12. Die Steuereinheit 12 ist auf dem Gehäuse 2 des Moduls 1 z.B. mittels Schrauben 10, welche durch entsprechende Schraubenlöcher 11 geführt sind, befestigt. Das Modulgehäuse 2 kann ebenfalls Schraubenlöcher 8 aufweisen, welche der Befestigung in einer Anlage dienen. Das Leistungshalbleitermodul 1 weist eine Anzahl Steuer- und Hilfsanschlüsse 13, welche mit der Steuereinheit 12, insbesondere durch eine Steckverbindung, verbunden sind. Die Steuer- und Hilfsanschlüsse dienen einerseits dem Einund Ausschalten des Moduls 1 und andererseits zu dessen Überwachung. Das Modul 1 weist ausserdem mindestens zwei Leistungsanschlüsse 5 und 6 auf, welche seitlich aus dem Gehäuse 2 herausgeführt sind. Im Falle eines Halbbrückenmoduls ist ausserdem ein Lastanschluss 7 vorgesehen. Da die Steuereinheit 12 direkt auf das Gehäuse 2 des Moduls aufgepackt ist, können die Anschlussleitungen zwischen den Steuer- und Hilfsanschlüssen 13 und der Steuereinheit sehr kurz und damit niederinduktiv gewählt werden.

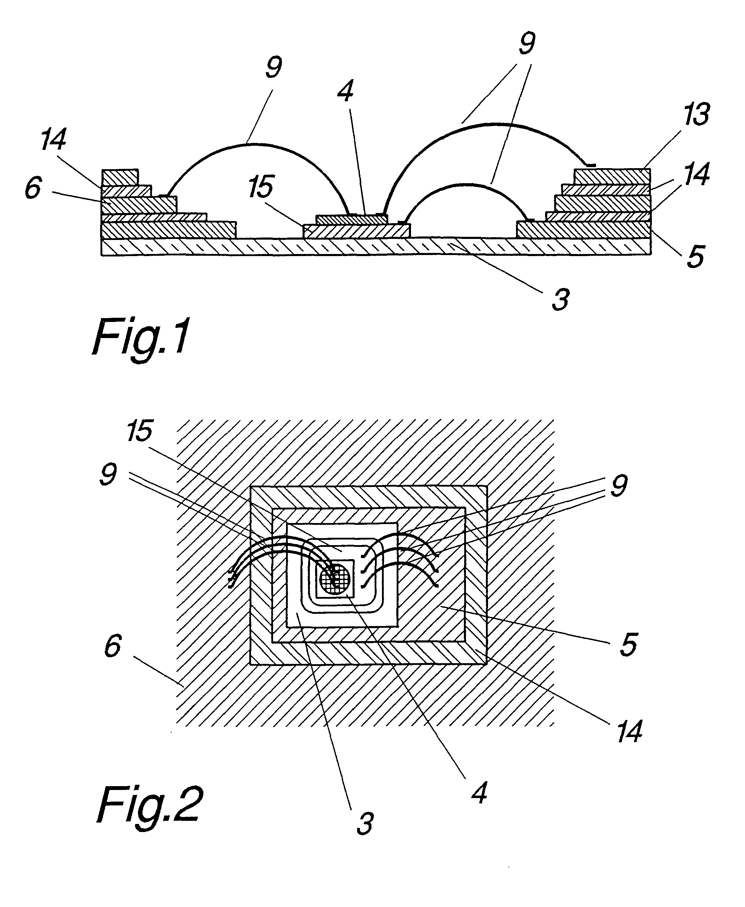

Dies wird dadurch erreicht, dass, wie in Figur 1 grundsätzlich dargestellt ist, die Leistungsanschlüsse 5 und 6 parallel zu einer Grundplatte 3 verlaufen, auf welche ein Leistungshalbleiterschaltelement 4 aufgebracht ist. Beim Leistungshalbleiterschaltelement handelt es sich insbesondere um einen IGBT-Chip, d.h. um einen Bipolartransistorchip mit isoliert angeordnetem Gate. Wie die Figur 2 von oben und Figur 1 im Schnitt zeigt kann die Verbindung zwischen den Leistungselektroden und den entsprechenden Leistungsanschlüssen 5 bzw. 6 zum Beispiel mittels Bonddrähten 9 hergestellt werden.

Ein Leistungshalbleitermodul 1 nach der Erfindung ist also grundsätzlich wie folgt aufgebaut: Auf einer Grundplatte 3, z.B. eine 8mm dicke Kupferplatte, welche ggf. auch gerade noch als Kühler dienen kann, werden Keramiksubstrate 15 gelötet. Die Substrate sind jeweils einem Schaltelement 4 zugeordnet. Dieses umfasst z.B. mindestens einen IGBT-Chip mit zugehöriger Freilaufdiode. Die Substrate 15 sind ganzflächig metallisiert. Die Leistungsanschlüsse 5, 6 und ggf. 7 werden von der Seite mittels Verbindungsleitungen 9, insbesondere mittels Bonddrähten ("Wirebonds") oder gelöteten Bändern ("Solderclips"), zugeführt. Die Verbindungsleitungen 9 führen zu den entsprechenden Leistungsanschlüssen 5 und 6, ggf. zum Lastanschluss 7 und zu den Steuer- und Hilfsanschlüssen 13, welche in verschiedenen Ebenen angeordnet sind und parallel zur Grundplatte verlaufen.

Die Leistungsanschlüsse 5,6 und ggf. 7 werden parallel zur Grundplatte 3 seitlich aus dem Gehäuse 2 herausgeführt. Im Gegensatz zu den Leistungsanschlüssen 5, 6 und ggf. 7 sind die Hilfs- und Steueranschlüsse 13 rechtwinklig zur Grundplatte 3 herausgeführt . Mit diesen Anschlüssen kann die Steuereinheit 12 durch einfaches Aufstecken auf die entsprechenden Anschlüssen verbunden werden.

Wird nun derjenige Leistungsanschluss, z.B. 6, am weitesten entfernt von der Grundplatte 3 und am nächsten bei der Steuereinheit 12 angeordnet, welcher auf das elektrische Potential bezogen am wenigsten von demjenigen der Steuereinheit 12 abweicht, so dient dieser Leistungsanschluss ausserdem auch noch als elektromagnetische Abschirmung. Diese schützt die Steuereinheit 12 vor dem Einfluss der durch das Schalten des Moduls hervorgerufenen elektromagnetischen Felder. Diese Felder werden durch die hohen Ströme und Spannungen hervorgerufen, welche mit dem Modul in möglichst kurzer Zeit geschaltet werden sollen. Die Felder können ohne spezielle Abschirmung zu schwerwiegenden Fehlfunktionen einer leistungselektronischen Schaltungsanordnung führen und behindern neben anderen Einflussfaktoren auch die Weiterentwicklung zu höheren Schaltfrequenzen.

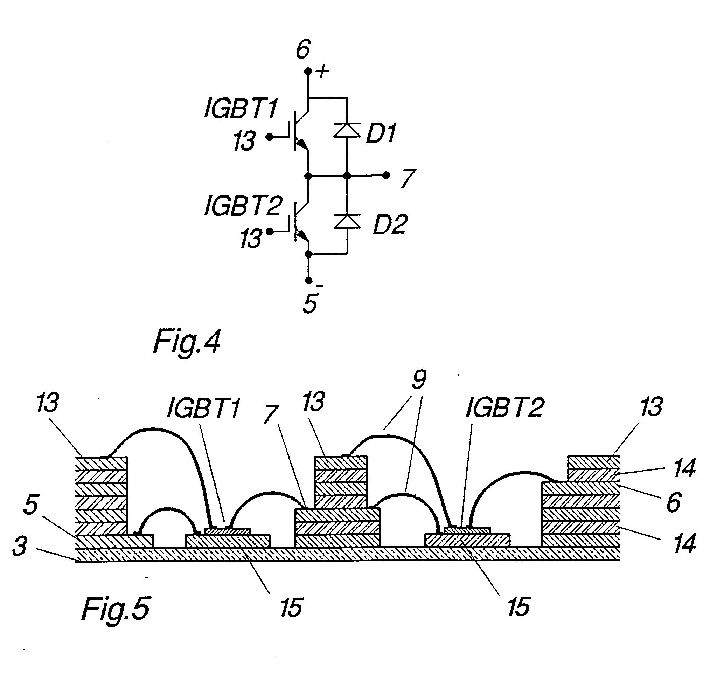

Mit dem erfindungsgemässen Aufbau ist auch möglich, ganze Halbbrückenmodule oder sogar noch umfangreichere leistungselektronische Schaltungen, z.B. ein Dreiphasenmodul, aufzubauen. Figur 4 zeigt das Ersatzschaltbild einer Halbbrücke. Hierbei sind zwischen einem Plus- und einem Minusanschluss zwei Schaltelemente 4 in Serie geschaltet. Bei den Schaltelementen handelt es jeweils um mindestens einen Schalterchip, hier in Form eines IGBTs (IGBT1, IGBT2), mit dazugehöriger Freilaufdiode D1, D2. Der gemeinsame Knotenpunkt entspricht dabei dem Lastanschluss 7, der Plus- und Minusanschluss entspricht den Lastanschlüssen 5 und 6. Die beiden IGBTs werden von je einem Gate- oder Steueranschluss 13 angesteuert.

Figur 5 zeigt ein solches Modul im Schnitt: Auf der Grundplatte 3 sind die Substrate 15 der Schaltelemente 4, d.h. der IGBTs (IGBT1, IGBT2, 4) angebracht. Die Leistungsanschlüsse 5 und 6 sowie der gemeinsame Lastanschluss 7 sind in verschiedenen Ebenen angeordnet und werden über die Anschlussdrähte 9 mit den entsprechenden Elektroden der Halbleiterschalter verbunden. Im dargestellten Beispiel sind die beiden Steueranschlüsse 13 der IGBTs auf derselben Anschlussebene angeordnet. In diesem Fall ist die entsprechende Anschlussebene, z.B. mittels Leiterbahnen, strukturiert, so dass die Anschlüsse elektrisch getrennt werden. Zwischen zwei benachbarten Ebenen bzw. Anschlüssen müssen Isolierschichten 14 eingelegt sein. Es ist selbstverständlich auch denkbar, auf beiden Seiten der Grundplatte 3 Substrate und Schaltelemente anzuordnen.

Wird ein solches Halbbrückenmodul in einen Aufbau wie in Figur 3 dargestellt integriert, so wird der Lastanschluss 7 in der Figur auf eine Seite herausgeführt und die Leistungsanschlüsse 5 und 6 in verschiedenen Ebenen auf die gegenüberliegende Seite. Deutlich zu sehen ist auch, wie die Steuereinheit 12 auf die Steuer- und Hilfsanschlüsse 13 aufgesteckt ist. Die Verbindung zur Steuereinheit 12 kann z.B. mittels einfacher Steck- oder Schraubverbindungen erfolgen.

Mit dem erfindungsgemässen Aufbau eines Leistungshalbleitermoduls ist also möglich, niederinduktive und damit schnelle aber dennoch elektromagnetisch gut verträgliche Schaltungsanordnung zu bauen. Dies ist im Hinblick auf höhere Schaltfrequenzen von grösster Bedeutung.

### Bezeichnungsliste

- 1: Leistungshalbleitermodul
- 2: Gehäuse
- 3: Grundplatte
- 4: Leistungshalbleiterschalterelement
- 5: Leistungsanschluss
- 6: Leistungsanschluss
- 7: Lastanschluss
- 8: Schraubenlöcher
- 9: Verbindungsleitung
- 10: Schrauben
- 11: Schraubenlöcher
- 12: Steuereinheit
- 13: Steuer- und Hilfsanschlüsse
- 14: Isolationsschicht
- 15: Substrat

## Patentansprüche

1. Leistungshalbleitermodul (1) umfassend ein Gehäuse (2) sowie eine Grundplatte (3), auf welcher mindestens ein Leistungshalbleiterschaltelement (4) angeordnet ist, wobei das Leistungshalbleiterschaltelement (4) mindestens zwei Leistungselektroden aufweist, welche mit entsprechenden Leistungsanschlüssen (5,6) verbunden sind, welche Leistungsanschlüsse (5,6) parallel zur Grundplatte (3) in mehreren Ebenen übereinander verlaufen und parallel zur Grundplatte (3) aus dem Gehäuse (2) herausgeführt sind sowie mit Anschlussdrähten (9) mit den entsprechenden Leistungselektroden des Leistungshalbleiterschaltelements (4) verbunden sind, wobei eine Anzahl von Steuer- und Hilfsanschlüssen (13) rechtwinklig zur Grundplatte (3) aus dem Gehäuse (2) herausgeführt sind, **dadurch gekennzeichnet, dass** die Anzahl von Steuer-und Hilfsanschlüssen fur ein Aufstecken einer das Modul (1) ansteuernden Steuereinheit (12) ausgebildet sind und dass auf dem Gehäuse (2) Befestigungsmittel (10,11) für die Steuereinheit (12) vorgesehen sind.

2. Modul nach Anspruch 1, **dadurch gekennzeichnet, dass** derjenige Steueranschluss am weitesten von der Grundplatte (3) entfernt und am nächsten bei der Steuereinheit (12) angeordnet ist, welcher die kleinste Potentialdifferenz zur Steuereinheit (12) aufweist.

3. Schaltungsanordnung mit mindestens einem Leistungshalbleitermodul (1), das mit einer das Modul (1) ansteuernden Steuereinheit (12) verbunden ist, **dadurch gekennzeichnet, dass** das Modul (1) nach einem der Ansprüche 1 bis 2 aufgebaut ist und die Steuereinheit (12) parallel zur Grundplatte (3) auf dem Gehäuse (2) des Moduls (1) angeordnet ist.

## Claims

1. Power semiconductor module (1) comprising a housing (2) and a baseplate (3), on which at least one power semiconductor switching element (4) is arranged, the power semiconductor switching element (4) having at least two power electrodes which are connected to corresponding power connections (5, 6), which power connections (5, 6) extend parallel to the baseplate (3) above one another in a plurality of planes and are passed out of the housing (2) parallel to the baseplate (3) and are connected to the corresponding power electrodes of the power semiconductor switching element (4) by means of connecting wires (9), a number of control and auxiliary connections (13) being passed out of the housing (2) at right angles to the baseplate (3), **characterized in that** the number of control and auxiliary connections are designed for plugging on of a control unit (12) which drives the module (1), and **in that** fastening means (10, 11) are provided on the housing (2) for the control unit (12).

2. Module according to Claim 1, **characterized in that** that control connection which has the smallest potential difference with respect to the control unit (12) is arranged the furthest away from the baseplate (3) and the nearest to the control unit (12).

3. Circuit arrangement comprising at least one power semiconductor module (1) which is connected to a control unit (12) which drives the module (1), **characterized in that** the module (1) is structured according to one of Claims 1 to 2 and the control unit (12) is arranged parallel to the baseplate (3) on the housing (2) of the module (1).

## Revendications

1. Module semiconducteur de puissance (1) comprenant un boîtier (2) ainsi qu'une plaque de base (3) sur laquelle est disposé au moins un élément de commutation à semiconducteur de puissance (4), l'élément de commutation à semiconducteur de puissance (4) présentant au moins deux électrodes de puissance qui sont reliées avec les bornes de puissance (5, 6) correspondantes, lesquelles bornes de puissance (5, 6) s'étendent parallèlement à la plaque de base (3) dans plusieurs plans superposés et sortent du boîtier (2) parallèlement à la plaque de base (3) et sont également reliées par le biais de fils de liaison (9) avec les électrodes de puissance correspondantes de l'élément de commutation à semiconducteur de puissance (4), un certain nombre de bornes de commande et auxiliaires (13) sortant du boîtier (2) perpendiculairement à la plaque de base (3), **caractérisé en ce que** le certain nombre de bornes de commande et auxiliaires (13) est configuré pour l'enfichage d'un bloc de commande (12) qui commande le module (1) et que des moyens de fixation (10, 11) du bloc de commande (12) sont prévus sur le boîtier (2).

2. Module selon la revendication 1, **caractérisé en ce que** la borne de commande qui est la plus éloignée de la plaque de base (3) et qui est disposée la plus proche du bloc de commande (12) est celle qui présente la plus petite différence de potentiel par rapport au bloc de commande (12).

3. Arrangement de commutation comportant au moins un module semiconducteur de puissance (1) qui est relié à un bloc de commande (12) qui commande le module (1), **caractérisé en ce que** le module (1) est construit selon l'une des revendications 1 à 2 et le bloc de commande (12) est disposé parallèlement à la plaque de base (3) sur le boîtier (2) du module (1).
